# EUROPEAN PATENT APPLICATION

(11) **EP 4 408 141 A1**
(43) Date of publication of application: **31.07.2024**
(21) Application number: 23215799.0
(22) Date of filing: 12.12.2023
(51) Int. Cl.: H10K 59/121, H10K 59/80

(54) **LIGHT EMITTING DISPLAY DEVICE**

(30) Priority: 27.01.2023 KR 20230010975
(71) Applicant: LG Display Co., Ltd., Seoul 07336 (KR)
(72) Inventor: Yu, Hyeon-Hye, 10845 Paju-si (KR); Lee, In-Goo, 10845 Paju-si (KR)
(74) Representative: Ter Meer Steinmeister & Partner

(57) **Abstract**

A light emitting display device includes: a bank on a substrate and including an opening which corresponds to an emission region of a pixel region; an inclined reflective portion below the bank and disposed in the pixel region; a light emitting diode at the emission region and including an emission layer and first and second electrodes which are disposed below and on the emission layer, respectively; and a plurality of light reflectors inside the light emitting diode and having a lower refractive index than that of the emission layer, wherein a first interface between the emission layer and the bank is circular or elliptical, and the light reflector forming a second interface with the emission layer is linear, and wherein at least a portion of the light reflector is disposed in a caustic region which is a total reflection optical path region made by total reflection along the first interface.

## Description

The present application claims the priority benefit of Korean Patent Application No. 10-2023-0010975 filed in Republic of Korea on January 27, 2023.

### BACKGROUND

### Field of the Disclosure

The present disclosure relates to a light emitting display device.

### Discussion of the Related Art

Recently, flat panel display devices having excellent characteristics such as thinness, light weight, and low power consumption have been widely developed and applied to various fields.

Among the flat panel display devices, a light emitting display device including a light emitting element, such as a light emitting diode, is a display device in which charges are injected into a light emitting layer formed between an anode and a cathode to form pairs of electrons and holes, and then the pairs disappear to emit light.

The light emitting display device does not have high light efficiency and thus needs to be improved.

### SUMMARY

An object of the present disclosure is to provide a display device with improved light efficiency.

The object is solved by the features of the independent claim. Additional features and advantages of the disclosure will be set forth in the description which follows, and in part will be apparent from the description, or may be learned by practice of the disclosure. These and other advantages of the disclosure will be realized and attained by the structure particularly pointed out in the written description and claims hereof as well as the appended drawings.

According to one aspect, a light emitting display device includes: a bank on a substrate and including an opening which corresponds to an emission region of a pixel region; an inclined reflective portion below the bank and disposed in the pixel region; a light emitting diode at the emission region and including an emission layer and first and second electrodes which are disposed below and on the emission layer, respectively; and a plurality of light reflectors inside the light emitting diode and having a lower refractive index than that of the emission layer, wherein a first interface between the emission layer and the bank is circular or elliptical, and the light reflector forming a second interface with the emission layer is linear, and wherein at least a portion of the light reflector is disposed in a caustic region which is a total reflection optical path region made by total reflection along the first interface.

According to a further aspect, a light emitting device comprises: a bank disposed on a substrate and including an opening which corresponds to an emission region of a pixel region; an inclined reflective portion below the bank and disposed in the pixel region; a light emitting diode disposed in the emission region and including an emission layer and a first electrode disposed below the emission layer and a second electrode disposed on the emission layer; and a plurality of light reflectors disposed within the light emitting diode and having a refractive index less than a refractive index of the emission layer, wherein a first interface between the emission layer and the bank is non-linear, and a first light reflector of the plurality of light reflectors forms a linear interface with the emission layer, and wherein at least a portion of a light reflector is disposed in a caustic region along the first interface.

According to a further aspect, a light emitting device comprises: a light emitting diode at an emission region and including an emission layer and a first electrode is disposed below the emission layer and a second electrode is disposed on the emission layer; an inclined light reflector disposed around the light emitting diode; and a plurality of light reflectors inside the light emitting diode and having a lower refractive index than a refractive index of the emission layer, wherein a first interface along a boundary of the pixel is non-linear, and the inclined light reflector forms a linear interface with the emission layer, and wherein at least a portion of a light reflector is disposed in a caustic region.

According to a further aspect, a light emitting device comprises: an emission region disposed on a substrate and configured to emit light in a normal direction; a plurality of light reflectors configured to change a direction of light traversing a lateral path; and a boundary light reflector disposed around a pixel region and configured to reflect the light traversing the lateral path towards a color filter.

According to a further aspect, a light emitting display device includes: a bank on a substrate and including an opening which corresponds to an emission region of a pixel region; an inclined reflective portion on the bank and disposed in the pixel region; a light emitting diode at the emission region and including an emission layer and first and second electrodes which are disposed below and on the emission layer, respectively; and a plurality of light reflectors inside the light emitting diode and having a lower refractive index than that of the emission layer, wherein a first interface between the emission layer and the bank is circular or elliptical, and the light reflector forming a second interface with the emission layer is linear, and wherein at least a portion of the light reflector is disposed in a caustic region which is a total reflection optical path region made by total reflection along the first interface.

According to yet a further aspect, a light emitting display device includes: a bank on a substrate and including an opening which corresponds to an emission region of a pixel region; a light emitting diode at the emission region and including an emission layer and first and second electrodes which are disposed below and on the emission layer, respectively; an inclined reflector disposed around the light emitting diode; and a plurality of light reflectors inside the light emitting diode and having a lower refractive index than that of the emission layer, wherein a first interface between the emission layer and the bank is circular or elliptical, and the light reflector forming a second interface with the emission layer is linear, and wherein at least a portion of the light reflector is disposed in a caustic region which is a total reflection optical path region made by total reflection along the first interface.

According to yet a further aspect, a light emitting display device includes: a substrate on which at least one pixel region with an emission region is defined; a bank on the substrate and including an opening corresponding to the emission region of the pixel region; a light emitting diode in the pixel region, in particular in the emission region, and including a first electrode, an emission layer on the first electrode and a second electrode on the emission layer; an inclined reflector disposed around the light emitting diode; and a plurality of light reflectors disposed within the pixel region, in particular within the emission region, and inside the light emitting diode, wherein a first interface between the emission layer and the bank is non-linear (e.g. circular or elliptical), and a second interface between at least one of the light reflectors and the emission layer is linear, and wherein at least a portion of the light reflector is disposed in a caustic region along the first interface.

The light emitting device according to any one of the preceding aspects may include one or more of the following features:

The first interface between the emission layer and the bank and/or a boundary of the pixel region and/or a boundary of the emission region may be non-linear, e.g. curved or curved in a plan view (plane parallel to the substrate). That is, the pixel region and/or the emission region may have a circular or elliptical or polygonal (e.g. n>4) shape.

The interface formed by one of the light reflectors, e.g. the first light reflector, with the emission layer may be denoted as second interface. The second interface between the light reflector and the emission layer may be linear or linear in a plan view (plane parallel to the substrate). The second interface between the light reflector and the emission layer may be a planar surface. More than one of or all of the plurality of light reflectors may form a linear or planar second interface with the emission layer.

At least one or each of the plurality of light reflectors may have a lower refractive index than that of the emission layer.

At least one of the plurality of light reflectors, e.g. the first light reflector or another light reflector except the first light reflector, may be disposed at least partially in the caustic region.

The caustic region may be an envelope of light (rays) which have been reflected by a curved surface of the first interface. In other words, the caustic region may be an envelope of light paths travelled by light which has been reflected by a curved surface of the first interface. Also, the caustic region may be a total reflection optical path region made by total reflection along the first interface, i.e. a region of optical paths travelled by light being reflected by total reflection along the first interface.

Waveguide mode light may denote light that travels within the light emitting device, in particular within the light emitting diode, like within a waveguide. In particular, waveguide mode light may denote light emitted by the light emitting diode and travelling laterally, i.e. parallel to a surface of the substrate. Whispering gallery mode light may denote light undergoing total internal reflection along an interface such as a curved surface, e.g. resulting in light propagation in circulating waveguide modes. Whispering gallery mode light may be trapped within the light emitting device, in particular within the light emitting diode.

The inclined reflective portion may also be denoted as inclined light reflector or as a boundary light reflector. The inclined reflective portion may be a portion of the first electrode, in particular an end portion or periphery portion or circumferential portion of the first electrode. The inclined reflective portion may be disposed within the pixel region. The inclined reflective portion may be disposed below the bank. That is, the bank may be disposed on the inclined reflective portion, i.e. may be covering the inclined reflective portion.

The plurality of light reflectors may be disposed within the pixel region, in particular within the emission region. The plurality of light reflectors may be disposed inside the light emitting diode, e.g. the light reflectors may be disposed between the first electrode and the second electrode.

The first light reflector and at least one second light reflector of the plurality of light reflectors may have different orientations (i.e. extension directions), i.e. in a plan view (plane parallel to the substrate). That is, at least two of the light reflectors may be disposed in an angle larger than 0° and smaller than 180° with respect to each other.

Light incident to the first light reflector may be configured to be reflected to the inclined reflective portion. That is, the first light reflector may be configured to reflect light incident thereto to the inclined reflective portion.

The light reflector, e.g. the first light reflector and/or another light reflector and/or each light reflector, may have a height equal to or greater than that of a portion of the emission layer around the light reflector. Here, height may refer to a dimension in normal direction, i.e. perpendicular to the substrate.

The height of the light reflector may be less than a height of the bank.

At least one of the light reflectors, in particular the light reflector disposed in the caustic region, may include: a first portion having a height equal to or greater than a height of the portion of the emission layer and/or having a side surface (or lateral surface) which has a first inclination angle (e.g. 90°, i.e. the side surface may extend in normal direction). In addition, the light reflector may include a second portion located on the first portion. The second portion may have a side surface which has a second inclination angle smaller than the first inclination angle, e.g. the second inclination angle smaller than 90°. That is, the second portion may have a tapered or trapezoid shape.

The inclined reflective portion may have a circular or elliptical shape corresponding to a shape of the first interface.

The inclined reflective portion may extend from the first electrode.

The light emitting diode or light emitting device may be configured in a top emission type.

Light entering the caustic region may be reflected along an outer boundary of the caustic region that prevents the light from leaving the caustic region, and/or a portion of the light reflector disposed in the caustic region may cause light to exit the caustic region. That is, a portion of the light reflector disposed in the caustic region may be configured to cause light to exit the caustic region. The caustic region may be configured to prevent light from leaving the caustic region by reflecting light entering the caustic region along an outer boundary of the caustic region.

The inclined reflective portion or the inclined light reflector may extend from the first electrode and/or may be disposed below a/the bank. Here, the light emitting diode or light emitting device may be configured in a top emission type.

The inclined reflective portion or the inclined light reflector may extend from the second electrode and/or may be disposed on a/the bank. Here, the light emitting diode or light emitting device may be configured in a bottom emission type.

The inclined reflective portion or the inclined light reflector may be disposed around the light emitting diode.

The inclined reflective portion or the inclined light reflector may be configured to reflect light traveling in a lateral direction towards the normal direction and/or towards a color filter of the light emitting device. The light emitting device may include a color filter on the light emitting diode.

The first interface may be an interface between the emission layer and the bank and/or along a boundary of the pixel.

The emission region may be configured to emit light in a normal direction, e.g. in a direction perpendicular to the substrate.

The plurality of light reflectors may be configured to change a direction of light, in particular of light traversing a lateral path.

The plurality of light reflectors may be configured to redirect light towards the boundary light reflector or towards the inclined reflective portion or towards the inclined light reflector. Each of the plurality of light reflectors may be configured to is configured to change a direction of light traveling in a lateral direction, i.e. in a direction parallel to the substrate.

A or each light reflector of the plurality of light reflectors may be disposed on an electrode in the emission region and/or may comprise a side surface that is perpendicular to an/the electrode.

A first portion of the side surface that is perpendicular to the electrode may have a height corresponding to a height of an emission layer.

The light reflector may comprise a top portion that is tapered to correspond to an angle of the boundary light reflector or the inclined reflective portion or the inclined light reflector. A height of the light reflector may be lower than a height of the boundary light reflector or the inclined reflective portion or the inclined light reflector.

It is to be understood that both the foregoing general description and the following detailed description are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this specification, illustrate aspects of the disclosure and together with the description serve to explain the principles of the disclosure. In the drawings:
FIG. 1 is a schematic cross-sectional view illustrating a light emitting display device according to a first aspect of the present disclosure;
FIG. 2 is a schematic plan view illustrating a light extraction structure of a pixel region according to a first aspect of the present disclosure;
FIG. 3 is a schematic view illustrating a caustic region showing a total reflection rotation path of a waveguide mode light of a light emitting diode according to a first aspect of the present disclosure;
FIG. 4 is a schematic view illustrating an arrangement relationship between a light reflector and a caustic region and an extraction mechanism of a waveguide mode light according to a first aspect of the present disclosure;
FIG. 5 is a view illustrating light reflectors arranged in a symmetrical form while facing each other in parallel according to a comparative example;
FIG. 6 is a view illustrating light reflectors having different orientations and arranged in an asymmetrical form according to aspects of the present disclosure;
FIG. 7 is a schematic cross-sectional view illustrating an example of a cross-sectional structure of a light reflector according to aspects of the present disclosure; and
FIG. 8 is a schematic cross-sectional view illustrating a cross-sectional structure of a light emitting display device according to aspects of the present disclosure.

### DETAILED DESCRIPTION

Advantages and features of the present disclosure and methods of achieving them will be apparent with reference to the aspects described below in detail with the accompanying drawings. However, the present disclosure is not limited to the aspects disclosed below, but may be realized in a variety of different forms, and only these aspects allow the present disclosure to be complete. The present disclosure is provided to fully inform the scope of the disclosure to the skilled in the art of the present disclosure, and the present disclosure may be defined by the scope of the claims.

The shapes, sizes, proportions, angles, numbers, and the like disclosed in the drawings for explaining the aspects of the present disclosure are illustrative, and the present disclosure is not limited to the illustrated matters. The same reference numerals refer to the same components throughout the description.

Furthermore, in describing the present disclosure, if it is determined that a detailed description of the related known technology unnecessarily obscure the subject matter of the present disclosure, the detailed description thereof may be omitted. When 'comprising', 'including', 'having', 'consisting', and the like are used in this disclosure, other parts may be added unless 'only' is used. When a component is expressed in the singular, cases including the plural are included unless specific statement is described.

In interpreting the components, even if there is no separate explicit description, it is interpreted as including a margin range.

In the case of a description of a positional relationship, for example, when the positional relationship of two parts is described as 'on', 'over', 'above', 'below', 'beside', 'under', and the like, one or more other parts may be positioned between such two parts unless 'right' or 'directly' is used.

In the case of a description of a temporal relationship, for example, when a temporal precedence is described as 'after', 'following', 'before', and the like, cases that are not continuous may be included unless 'directly' or 'immediately' is used.

In describing components of the present disclosure, terms such as first, second and the like may be used. These terms are only for distinguishing the components from other components, and an essence, order, order, or number of the components is not limited by the terms.

Respective features of various aspects of the present disclosure may be partially or wholly connected to or combined with each other and may be technically interlocked and driven variously, and respective aspects may be independently implemented from each other or may be implemented together with a related relationship.

Hereinafter, aspects of the present disclosure are described in detail with reference to the drawings. Meanwhile, in the following aspects, the same and like reference numerals are assigned to the same and like components, and detailed descriptions thereof may be omitted.

### First Aspect

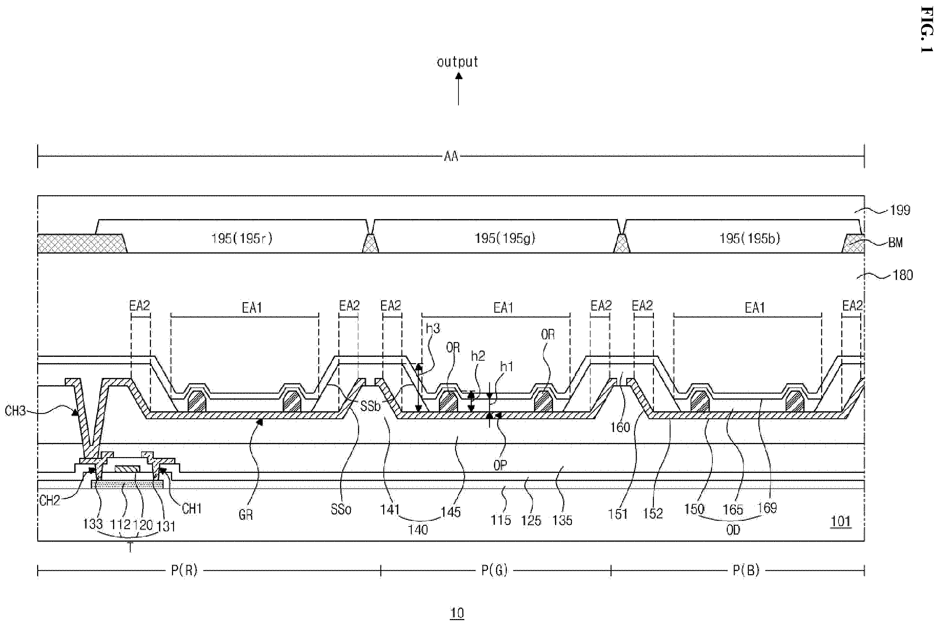

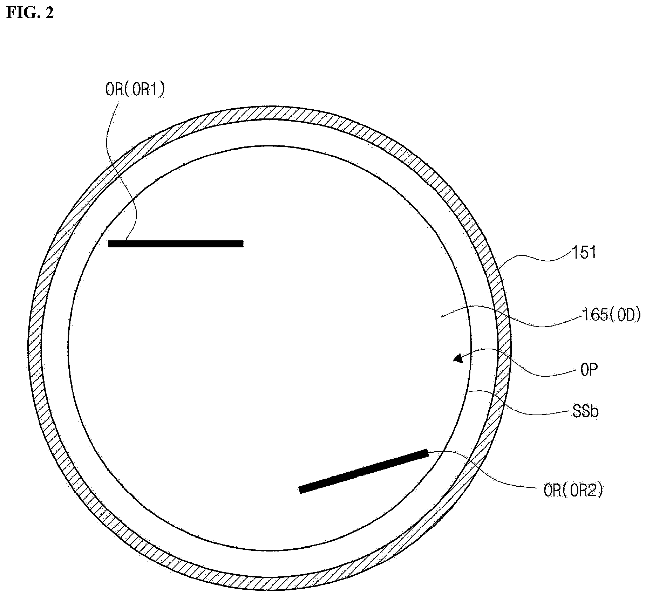

FIG. 1 is a schematic cross-sectional view illustrating a light emitting display device according to a first aspect of the present disclosure. FIG. 2 is a schematic plan view illustrating a light extraction structure of a pixel region according to a first aspect of the present disclosure.

Prior to a detailed description, a light emitting display device 10 according to the first aspect of the present disclosure may include all kinds of display devices including a light emitting diode (OD), which is a self-luminescent element, to display an image.

In some aspects, for convenience of description, the light emitting display device 10 may be an organic light emitting display device.

Referring to FIG. 1, the light emitting display device 10 of this aspect may be a top emission type display device that displays an image by outputting light toward an upper side of a substrate 101.

A plurality of pixel regions P are formed on the substrate 101 of the light emitting display device 10. The plurality of pixel regions may be arranged in a matrix form along a plurality of row lines and a plurality of column lines in a display region AA displaying an image. Although not shown in the drawings, a plurality of gate lines may be formed on the substrate 101 and extend in a row direction. A plurality of data lines may be formed on the substrate 101 and extend in a column direction. Each pixel region P may be connected to corresponding gate line and data line.

The plurality of pixel regions P may include pixel regions of different colors constituting a unit pixel displaying a color image, for example, red (R), green (G), and blue (B) pixel regions P respectively displaying red (R), green (G), and blue (B).

In each pixel region P, a plurality of thin film transistors, at least one capacitor, and a light emitting diode OD may be formed on the substrate 101. In the aspects illustrated in FIG. 1, for convenience of description, one thin film transistor T, for example, a driving thin film transistor T disposed in the red (R) pixel region P is shown.

In more detail, a semiconductor layer 112 may be formed on an inner surface of the substrate 101. Non limiting examples of the semiconductor layer 112 may be made of amorphous silicon, polycrystalline silicon, or an oxide semiconductor material.

The semiconductor layer 112 may include a central channel region and source and drain regions on both sides of the channel region.

A gate insulating layer 115 made of an insulating material may be formed on the semiconductor layer 112. Non-limiting examples of the gate insulating layer 115 include an inorganic insulating material such as silicon oxide or silicon nitride.

A gate electrode 120 comprises a conductive material such as a metal and may be formed on the gate insulating layer 115 to correspond to the channel region of the semiconductor layer 112.

In addition, a gate line connected to a gate electrode of a switching thin film transistor (not shown) may be formed on the gate insulating layer 115.

A first interlayered insulating layer 125 comprises an insulating material and may be formed on the gate electrode 120 and over the entire surface of the substrate 101.

The first interlayered insulating layer 125 may be formed of an inorganic insulating material such as silicon oxide or silicon nitride, or may be formed of an organic insulating material such as benzocyclobutene or photo acryl, but is not limited thereto.

In the first interlayered insulating layer 125 and the gate insulating layer 115 below the first interlayered insulating layer 125, a first contact hole CH1 and a second contact hole CH2 respectively may be provided to expose the source region and the drain region of the semiconductor layer 112.

The first contact hole CH1 and the second contact hole CH2 may be disposed on both sides of the gate electrode 120 and be separated from the gate electrode 120.

A source electrode 131 and a drain electrode 133 include a conductive material such as metal and may be formed on the first interlayered insulating layer 125.

In addition, a data line may be formed on the first interlayered insulating layer 125 that crosses the gate line and is connected to the source electrode of the switching thin film transistor.

The source electrode 131 and the drain electrode 133 may be seprated from each other with the gate electrode 120 therebewteen, and may contact the source region and the drain region of the semiconductor layer 112 through the first contact hole CH1 and the second contact hole CH2, respectively.

The semiconductor layer 112, the gate electrode 120, the source electrode 131, and the drain electrode 133, configured as above, may form the thin film transistor T.

As another example, the thin film transistor T may have an inverted staggered structure. For example, an inverted staggered structure includes the gate electrode 120 located below the semiconductor layer 112 and the source electrode 131 and the drain electrode 133 are located on the semiconductor layer 112.

A second interlayered insulating layer 135 comprises an insulating material and may be formed on the source electrode 131 and the drain electrode 133 and over the entire surface of the substrate 101.

The second interlayered insulating layer 135 may be formed of an inorganic insulating material such as silicon oxide or silicon nitride, but is not limited thereto.

An overcoat layer 140 (e.g., a planarization layer) may be formed on the second interlayered insulating layer 135. The overcoat layer 140 may be formed of an organic insulating material such as benzocyclobutene or photo acryl, but is not limited thereto.

A third contact hole (or drain contact hole) CH3 exposing the drain electrode 133 may be formed in the overcoat layer 140 and the second interlayered insulating layer 135.

The overcoat layer 140 may include protruding portions 141 (e.g., separation walls) that protrude upward along a boundary (or edge) of each pixel region P. The overcoat layer 140 may be formed with concave grooves GR defined inside the protrusion portions 141. In some aspects, a portion of the overcoat layer 140 may be positioned below the concave groove GR (or below a bottom surface of the concave groove GR) and may have a top surface (or upper surface) thereof which is substantially flat (e.g., planar). The portion of the overcoat layer 140 may be referred to as a flat portion 145 or a base portion.

The protruding portion 141 may be configured to have a tapered shape in which a width of the protruding portion 141 decreases in a direction from which light is emitted. Accordingly, the protruding portion 141 may be configured with an inclined surface Sso. In this regard, the inclined surface Sso of the protruding portion 141 may be configured to have a shape inclined at a certain angle in an outward direction based on the corresponding pixel region P. The inclined surface Sso may have a linear shape having a constant inclination angle or a protruding curved shape in which the inclination angle decreases from a lower end to an upper end (e.g., a non-linear shape). In this aspect, a case where the inclined surface Sso is linear is taken as an example.

The inclined surface Sso may surround the concave groove GR to define the concave groove GR. Accordingly, the concave groove GR may have the inclined surface Sso as side surface (or outer circumferential surface). In other words, an inclined side surface (or outer circumferential surface) of the concave groove GR may be or correspond to the inclined surface Sso.

A first electrode (or anode) 150 may be formed on the overcoat layer 140 in each pixel region P.

The first electrode 150 of each pixel region P may be positioned to correspond to each concave groove GR of the overcoat layer 140 and may have a structure separated from the first electrode 150 of a neighboring pixel region P with the protruding portion 141 interposed therebetween. For example, neighboring first electrodes 150 may be separated from each other on the upper surface of the protruding portion 141.

The first electrode 150 may include a metal material with high reflectance. Non-limiting examples of the first electrode 150 may include Al, Ag, Ti, or an Al-Pd-Cu (APC) alloy.

In some aspects, the first electrode 150 may have a single-layered structure or a multi-layered structure. When formed in a multi-layered structure, for example, the first electrode may have a laminated structure of Al and Ti (e.g., Ti/Al/Ti), a laminated structure of Al and ITO (e.g., ITO/Al/ITO), a laminated structure of an APC alloy and ITO (e.g., ITO/APC/ITO), etc., but is not limited thereto.

The first electrode 150 may include a reflective portion 151 (e.g., an inclined portion) that is formed along or on the inclined surface Sso of the overcoat layer 140. The reflective portion 151 may have a shape extending obliquely upward along the inclined surface Sso from the end of the portion of the first electrode 150 positioned on the flat portion 145 of the overcoat layer 140. The portion of the first electrode 150 positioned on the flat portion 145 of the overcoat layer 140 may be referred to as a flat portion 152 (or base portion) of the first electrode.

A bank 160 may be formed on the first electrode 150 to cover an edge of the first electrode. In some aspects, the bank 160 may be disposed along the boundary of the pixel region P and may cover the edge portion including the reflective portion 151 of the first electrode 150 and cover the protruding portion 141 of the overcoat layer 140. In some aspects, the bank 160 may be omitted based on the light emitting display device configuration and a manufacturing method of the same.

The bank 160 may be formed of, for example, at least one of acrylic resin, epoxy resin, phenol resin, polyamide resin, polyimide resin, unsaturated polyester resin, polyphenylene resin, polyphenylene sulfide resin, benzocyclobutene and photoresist, but is not limited thereto.

The bank 160 may have an opening OP therein exposing the first electrode 150 of each pixel region P, in particular exposing a portion of the flat portion 152 of the first electrode 150.

The bank 160 may be formed in substantially the same shape as (or a shape corresponding to) the overcoat layer 140.

In this regard, the bank 160 may be configured to have a tapered shape with a width decreasing in an upward direction. The tapered shape of the bank 160 may be the same as that of the protruding portion 141 of the overcoat layer 140 positioned therebelow.

Accordingly, the bank 160 may be configured such that the side surface (or inner side surface) is an inclined surface SSb. The inclined surface SSb of the bank 160 may have substantially the same or based on inclination angle of the inclined surface Sso of the protrusion portion 141 located therebelow.

The inclined surface SSb of the bank 160 may surround the opening OP. Accordingly, the opening OP may have an inclined side surface (or outer circumferential surface) corresponding to the inclined surface SSb.

The opening OP may expose the flat portion 152 of the first electrode 150. In one aspect, the bank 160 may be configured to cover the edge of the flat portion 152 of the first electrode 150, and the opening OP may expose a portion of the flat portion 152 except for the edge of the flat portion 152.

An emission layer 165 may be formed on the first electrode 150 of each pixel region P. The emission layer 165 may contact the first electrode 150 exposed through the opening OP of the bank 160.

The emission layer 165 may be formed separately in each pixel region P or may be formed continuously along the entire surface of the substrate 101 to correspond to all pixel regions P. In this aspect, for convenience of explanation, a case in which the emission layer 165 is formed in each pixel region P is taken as an example.

All of the emission layers 165 in respective pixel regions P may be formed of white emission layer emitting white light. As another example, the emission layer 165 of each pixel region P may be formed of an emission layer emitting the color of its pixel region P, for example, red ^{®}, green (G), and blue (B) pixel regions P may respectively have r^{®}(R), green (G), and blue (B) emission layers.

The emission layer 165 may have a higher refractive index than the bank 160. For example, the emission layer 165 may have a refractive index (or first refractive index) of about 1.8 to 2.0, and the bank 160 may have a refractive index (or second refractive index) of about 1.5 to 1.6 lower than that of the emission layer 165, but are not limited thereto.

Due to the difference in refractive indexes, total reflection may occur for light traveling in a horizontal direction (or lateral direction) at an interface between the emission layer 165 and the bank 160.

A second electrode 169 such as a cathode may be formed on the emission layer 165 and over the entire surface of the substrate 101.

The second electrode 169 may be formed of a transparent electrode. In one aspect, the second electrode 169 may be formed of a transparent conductive material such as ITO. The second electrode 169 may be formed by other transparent conductive materials.

Meanwhile, in a case of realizing a micro cavity effect in a vertical direction, the second electrode 169 may be configured to include a semi-transparent electrode layer having a semi-transparent property. For example, the second electrode 169 may have a multi-layered structure including the semi-transparent electrode layer. The semi-transparent electrode layer of the second electrode 169 may be formed of, but not limited to, for example, a metal material such as magnesium (Mg), silver (Ag), or an alloy (MgAg) of magnesium (Mg) and silver (Ag), and such the metal material may be formed with a thickness thin enough to realize semi-transparent property.

The first electrode 150, the emission layer 165, and the second electrode 169 arranged as described above in the pixel region P may constitute the light emitting diode OD.

The light emitting diode OD may emit light from the emission layer 165 interposed between the first electrodes 150 and second electrodes 169, and the emitted light may proceed upward and be output.

Meanwhile, some of the light generated from the emission layer 165 may propagate while being totally reflected in the lateral direction (or horizontal direction) of the pixel region P and may be trapped inside of the display device. The light travelling in lateral direction, in particular the light propagating while being totally reflected in the lateral direction and/or being trapped inside the display device, may be denoted as waveguide mode light. The waveguide mode light occurs when light is traveling in the lateral direction. In some aspects, the waveguide mode light may be reflected by the reflective portion 151 of the first electrode 150 disposed in the lateral direction of the light emitting diode OD and then emitted upward. As such, the reflective portion 151 of the first electrode 150 may reflect light traveling in a lateral direction in the upward direction.

Due to the reflective portion 151 of the first electrode 150, light extraction efficiency of the light emitting display device 10 may be increased.

A region corresponding to the first electrode 150 exposed by the opening OP may be an effective (or substantial) emission region in which the light emitting diode OD is disposed to generate light, and this region may be referred to as a first emission region (or main emission region) EA1. Further, a region where the reflective portion 151 is disposed may be referred to as reflective emission region in which light generated in the emission layer 165 located inside the region and then propagated in the lateral direction is reflected and emitted upward. The reflective emission region may be referred to as a second emission region (or sub emission region) EA2.

In some aspects, each pixel region P has an emission region including the first emission region EA1 and the second emission region EA2.

The first emission region EA1 may substantially correspond to a shape of the region corresponding to the first electrode 150 that is exposed through the opening OP, and the second emission region EA2 may have a shape that is at least partially separated from the first emission region EA1 (e.g., the spaced region may be referred to as a non-emission region) and surrounds the first emission region EA1. In some aspects, the bank 160 may be omitted and a single emission area can be formed based joining of emission areas EA1 and EA2.

An encapsulation layer 180 may be formed on the second electrode 169. The encapsulation layer 180 may serve to prevent oxygen or moisture from permeating into the light emitting diode OD.

The encapsulation layer 180 may include, for example, at least one inorganic layer and at least one organic layer. Although not specifically shown, for example, the encapsulation layer 180 may have a structure in which a first inorganic layer, an organic layer on the first inorganic layer, and a second inorganic film on the organic layer are stacked.

A black matrix BM and a color filter layer 195 may be disposed on the encapsulation layer 180.

In this regard, the black matrix BM may be formed to correspond to an edge of each pixel region P.

The color filter layer 195 may be formed to correspond to each pixel region P. The color filter layer 195 may include red, green, and blue color filters (or color filter patterns) 195r, 195g, and 195b respectively corresponding to the red (R), green (G), and blue (B) pixel regions P.

By disposing the color filters 195r, 195g, and 195b in the corresponding pixel regions P, a color purity of light emitted from the corresponding pixel regions P may be improved.

An overcoat film 199 may be formed on the black matrix BM and the color filter layer 195 to cover and protect the black matrix BM and the color filter layer 195. The substrate having the overcoat film 199 may have a substantially flat surface.

A mesh type touch electrode (not shown) may be disposed between the encapsulation layer 180 and the color filter layer 195. The touch electrode may be formed of electrode metal patterned in a mesh type. Accordingly, a plurality of opening regions may formed in a touch electrode region, and each opening region may correspond to each pixel region P.

In each pixel region P, the opening OP of the bank 160 may be provided and the reflective portion 151 of the first electrode 150 may surround the opening OP. At least two light reflectors OR may be disposed in or included in the light emitting diode OD within the opening OP of the bank 160.

The mesh-type touch electrode may be arranged to overlap the black matrix BM but arranged not to overlap the opening OP and the reflective portion 151, thereby enabling a touch sensing and further increasing an aperture ratio and emission efficiency of the light emitting display device 10.

Meanwhile, in the light emitting display device 10 of this aspect configured as described above, the pixel region P may be formed in a circular or elliptical shape in plan view.

In this regard, for example, the opening OP and the light emitting diode OD disposed therein may be formed in a circular or elliptical shape in plan view. In addition, the reflective portion 151 surrounding the opening OP and the light emitting diode OD may also be formed in a circular shape or elliptical shape in plan view as a shape corresponding to the opening OP and the light emitting diode OD. More specifically, the reflective portion 151 may have a circular band or elliptical band shape in a plan view.

Meanwhile, in this aspect, for convenience of description, a case in which the pixel region P (or light emitting diode OD) is formed in a circular structure in plan view is taken as an example.

As such, when the pixel region P is formed in a circular structure, a whispering gallery mode light may occur within the light emitting display device 10 that travels around concave surfaces. For example, a whispering gallery mode light may be totally reflected along the interface between the emission layer 165 and the bank 160 (or its inclined surface SSb) to generate stable (or regular) light path (or light trajectory) inside the interface and trapped in the emission layer 165 without being output to an outside of the interface. In this case, the whispering gallery mode light may be absorbed by a medium and dissipated. Even in a case of an elliptical structure, a waveguide mode light of a stable path may be generated along the interface, similarly to a circular structure.

In this regard, in particular for a circular or elliptical pixel region P, to maximize light efficiency by extracting the rotating waveguide mode light along the interface between the emission layer 165 (e.g., a light emitting layer) and the bank 160 (or the inclined surface SSb of the bank 160), the light reflector (or refracting reflector or total reflector) OR which is linear in plan view may be formed in the light emitting diode OD (or in the opening OP of the bank 160).

As such, the linear light reflector OR blocks the light path of the waveguide mode light (e.g., the whispering gallery mode light) along the circular interface and disperses the light path. In some aspects, the linear light reflector OR changes the stable light path of the waveguide mode light (e.g., the whispering gallery mode light) and cause an unstable (or irregular or chaotic) state. The unstable waveguide mode light (e.g., the whispering gallery mode light) has an incident angle that is less than a critical angle of total reflection of the circular interface and may be extracted and utilized outside the circular interface, and as a result, light extraction efficiency may be maximized.

A light extraction structure in which the linear light reflector OR is applied to the circular (or elliptical) pixel region P (or light emitting diode OD) is described in detail below.

Referring to FIGs. 1 and 2, in the light emitting display device 10, a plurality of light reflectors OR may be formed inside the light emitting diode OD. Meanwhile, in this aspect, a case in which two light reflectors OR are disposed inside the light emitting diode OD is taken as an example.

The light reflector OR may be formed between the first electrode 150 and the emission layer 165 (e.g., a light emitting layer) in the opening OP.

In this regard, the light reflector OR may be formed such that it is formed on and in contact with the first electrode 150, and that it is covered by the emission layer 165. For example, the light reflector OR may be formed such that its lower surface (or bottom surface) contacts the upper surface (or top surface) of the first electrode 150, and its upper surface (or its top surface) and its side surface contact the emission layer 165.

In other words, the light reflector OR may be formed to protrude upward from the first electrode 150 and be covered (or wrapped) by the emission layer 165.

The light reflector OR may be formed of the same material and in the same process as the bank 160. In this case, there is no need to perform a separate process to form the light reflector OR, so that process efficiency may be improved.

As another example, the light reflector OR may be formed in a process different from that of the bank 160, and in this case, the light reflector OR may be formed of the same material as the bank 160 or a different material from the bank 160.

Meanwhile, the light reflector OR may have a refractive index (or third refractive index) that is lower than that of the emission layer 165 and may have a refractive index equal to or lower than that of the bank 160. For example, the light reflector OR may have a refractive index of about 1.5 to 1.6, but is not limited thereto.

Due to a difference in refractive index between the emission layer 165 and the light reflector OR, light having a critical angle of total reflection or higher may be reflected at an interface between the emission layer 165 and the light reflector OR.

As such, by forming the light reflector OR to have a lower refractive index than the emission layer 165, light reflection by total reflection is achieved on the surface of the light reflector OR (or the interface between the light reflector OR and the emission layer 165), so that the light reflector OR may reflect the waveguide mode light in the horizontal direction within the emission layer 165 to change the path of the waveguide mode light. Thus, the light reflector OR may prevent the occurrence of whispering gallery mode light.

Meanwhile, to change the path of the waveguide mode light in the horizontal direction and improve light extraction to the outside of the light emitting diode OD, the light reflector OR may be formed with a linear shape in plan view, as mentioned above.

In this regard, the total reflection interface of the light emitting diode OD (i.e., the side surface SSb of the bank 160), which is the total reflection interface (or first total reflection interface) between the emission layer 165 and the bank 160, may be increased in a display device having circular shape. If the light reflector OR is formed in a circular shape in the plan view, the waveguide mode light is reflected along a total reflection interface (or second total reflection interface) between the circular light reflector OR and the emission layer 165, thus a path change of the waveguide mode light is not large, and a change of an incident angle of light to the total reflection interface of the light emitting diode OD is not large. Accordingly, a light extraction efficiency of the waveguide mode light is not significantly improved.

On the other hand, in this aspect, when the light reflector OR is formed in a linear shape different from the circular shape, a total reflection interface may be formed for the light emitting diode OD.

Accordingly, the path of the waveguide mode light along the circular total reflection interface is changed by the total reflection interface of the linear light reflector OR, which has a different shape from the circular total reflection interface. In this case, the incident angle of light to the total reflection interface of the light emitting diode OD is changed based on the critical angle of total reflection. Accordingly, the light extraction efficiency of the waveguide mode light may be maximized.

As such, in this aspect, the light reflector OR implementing the linear total reflection interface is formed inside the light emitting diode OD and forms a circular total reflection interface with the bank 160.

As such, in the light emitting diode OD, as an optically simulated structure of a stadium billiard structure of a stadium shape in which an arc boundary surface and a straight boundary surface are combined and which is one of chaotic dynamics billiard structures, a chaotic dynamics structure may be implemented in which a circular total reflection interface and a linear total reflection interface inside the circular total reflection interface are combined to make a motion trajectory of light in a chaotic state.

Accordingly, by precluding formation of the stable path of the waveguide mode light along the circular total reflection interface and dispersing the light path, the path of the waveguide mode light may be made unstable. In some aspects, the incident angle of the waveguide mode light is changed to be less than the total reflection critical angle of the circular total reflection interface to maximize the light extraction efficiency from the light emitting display device 10.

In some aspects, to preclude formation of the path of the waveguide mode light along the circular total reflection interface, i.e. to prevent the occurrence of whispering gallery mode light, a portion of the light reflector OR is disposed to cross (or block) a total reflection rotation path of the waveguide mode light formed along the total reflection interface.

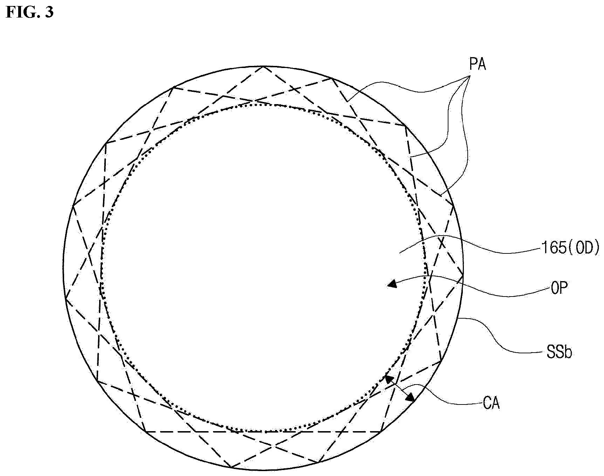

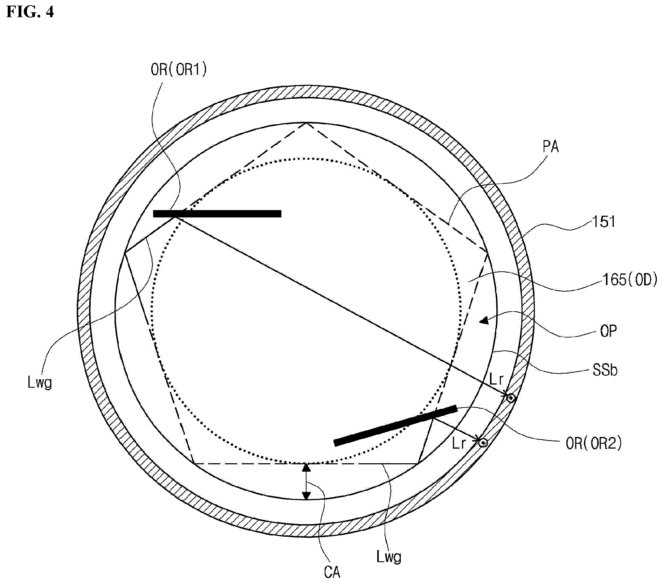

This is described with further reference to FIGs. 3 and 4.

FIG. 3 is a schematic view illustrating a caustic region having a total reflection rotation path of a waveguide mode light of a light emitting diode according to aspects of the present disclosure. FIG. 4 is a schematic view illustrating an arrangement relationship between a light reflector and a caustic region and an extraction mechanism of a waveguide mode light according to a first aspect of the present disclosure.

As shown in FIG. 3, the waveguide mode light continuously rotates along the circular total reflection interface of the light emitting diode OD (e.g., the side surface SSb of the bank 160). In this case, the waveguide mode light has stable rotational paths PA and is trapped inside of the display device. In some aspects, a total reflection optical path region CA exists within the display device wherein the waveguide mode light reflects based on the side surfaces. The total reflection optical path region may be defined by the rotational paths PA of the waveguide mode light.

According to some aspects, the caustic region CA corresponds to the total reflection optical path region CA and is defined the total reflection rotational paths PA of the waveguide mode light due to total reflection.

The caustic region CA may have a circular band shape (a ring shape, a donut shape, etc.) which has a certain width and has an outer side positioned at an interface between the emission layer 165 and the bank 160. In other words, the caustic region CA may have a circular band shape having a certain width from the interface between the emission layer 165 and the bank 160 toward the inside of the emission layer 165. Meanwhile, when the interface between the emission layer 165 and the bank 160 has an elliptical shape, the caustic region CA may have a corresponding elliptical band shape. The circular band shape may include an outer radius associated with an outer edge and an inner radius associated with an inner edge.

In this case, as shown in FIG. 4, the linear light reflector OR of this aspect may be disposed within the caustic region CA. For example, in FIG. 4, for convenience of description, an example in shown in which a portion of the light reflector OR is located in the caustic region CA. In another example, the entire light reflector OR may be disposed within the caustic region CA. As a result, at least a portion of the light reflector OR may be positioned within the caustic region CA.

When the linear light reflector OR is located in the caustic region CA, the waveguide mode light Lwg in the caustic region CA is reflected by the linear light reflector OR and the light path PA may be changed to prevent light from entering into the caustic region CA.

For example, the reflected light Lr having a light path PA is changed and has an incident angle lower than the critical angle of total reflection with respect to the interface between the emission layer 165 and the bank 160. In this case, the reflected light Lr may pass through the interface (or pass through the interface while being refracted).

The light Lr extracted through the interface is reflected by the inclined reflective portion 151 located in its traveling direction, and proceeds toward a top of the light emitting display device 10 to be output to the outside.

In this aspect, as mentioned above, the plurality of light reflectors OR may be disposed in the light emitting diode OD, and the plurality of light reflectors OR may be configured to have their length directions (or extension directions) or orientations (or normal directions, e.g. normal directions with respect to the reflector surface) different from each other, in particular non-parallel to each other.

In this regard, referring to FIGs. 2 and 4, for example, first second light reflector OR1 and second light reflector OR2 disposed at different positions as the plurality of light reflectors OR may be provided in the light emitting diode OD.

The orientation (or first orientation) of the first light reflector OR1 and the orientation (or second orientation) of the second light reflector OR2 may not be parallel to each other but may be different. In other words, the orientation of the first light reflector OR1 and the orientation of the second light reflector OR2 may not coincide with each other but may be different.

As the orientations of the light reflectors OR1 and OR2 disposed in the light emitting diode OD are configured differently from each other, asymmetry of the light reflectors OR1 and OR2 may be increased. Accordingly, light is reflected between the light reflectors OR1 and OR2 to prevent a length of the light path, thereby preventing light loss due to the length of the light path. In addition, as the asymmetry of the light reflectors OR1 and OR2 increases, the chaotic characteristics of the waveguide mode light increase, so that the light extraction efficiency may be increased.

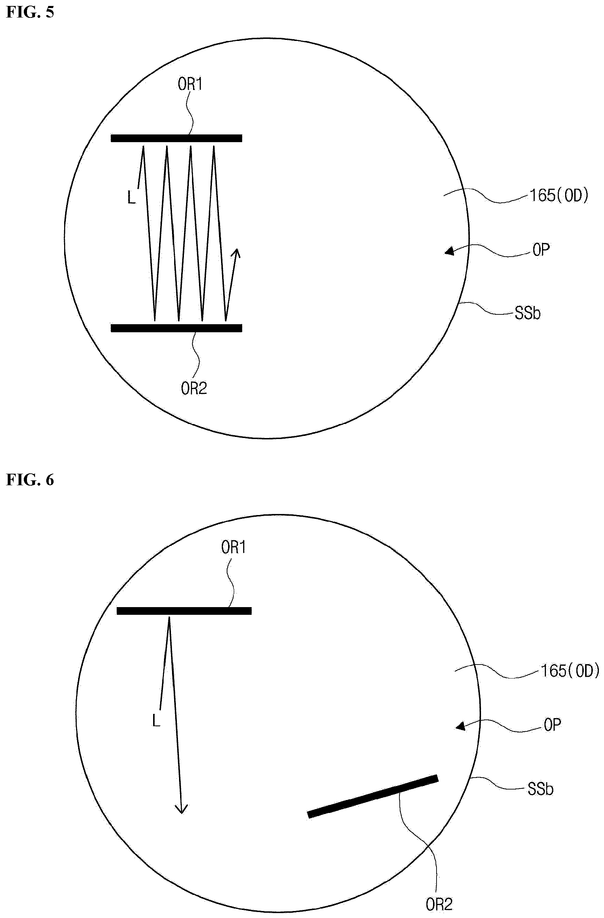

FIGs. 5 and 6 are referred to in relation to preventing light loss due to an increase in light path length caused by reflection between the light reflectors OR1 and OR2.

FIG. 5 is a view illustrating light reflectors arranged in a symmetrical form while facing each other in parallel according to a comparative example. FIG. 6 is a view illustrating light reflectors having different orientations and arranged in an asymmetrical form according to a first aspect of the present disclosure.

As shown in FIG. 5, in the comparative example, the first and second light reflectors OR1 and OR2 are symmetrically arranged to face each other in parallel. In this case, light L is continuously reflected between the first and second light reflectors OR1 and OR2, and the light path becomes increased. As the light path increases in length, an amount of light L absorbed by the medium increases, increasing the light loss.

On the other hand, as shown in FIG. 6, in this aspect, the first light reflector OR1 and second light reflector OR2 may be arranged in an asymmetrical form while having different length directions rather than being parallel to each other. In this case, for example, after being reflected by the first light reflector OR1, light L may not propagate to the second reflector OR2 to decrease the light path length and prevent reflection between the first light reflector OR1 and second light reflector OR2. Accordingly, it is possible to prevent loss due to an increase in light path length caused by reflection between the light reflectors OR1 and OR2.

Meanwhile, referring to FIG. 1, the light reflector OR of this aspect may have a height (or thickness) h2 (or a second height) that is equal to or greater than a height (or thickness) h1 (or first height) of the emission layer 165, which is located around the light reflector OR. In other words, the upper surface (or top) of the light reflector OR may have the height h2 equal to or greater than the height h1 of an upper surface of a portion of the emission layer 165 located around the light reflector OR (e.g., a portion of the emission layer 165 which is located in a flat shape on the first electrode 150 without covering the light reflector OR). The light reflector OR may have a height h2 equal to or greater than the height h1 of the upper surface of the light emitting layer 165. In one aspect, the light reflector OR may be formed to have the height h2 greater than that of the emission layer 165.

In this regard, if the light reflector OR has a height lower than that of the emission layer 165, a waveguide mode light traveling in the horizontal direction may pass over the light reflector OR and not be incident to the light reflector OR.

To prevent missed light reflection due to height, the light reflector OR may be configured to have the height h2 equal to or greater than the height h1 of the emission layer 165.

Furthermore, the light reflector OR may be formed to have the height h2 lower than a height (or thickness) h3 (or third height) of the bank 160. In other words, the upper surface of the light reflector OR may be formed to have the height h2 smaller than the upper surface of the bank 160. According to this configuration, it is possible to secure step coverage characteristics on the light reflector OR with respect to the second electrode 169.

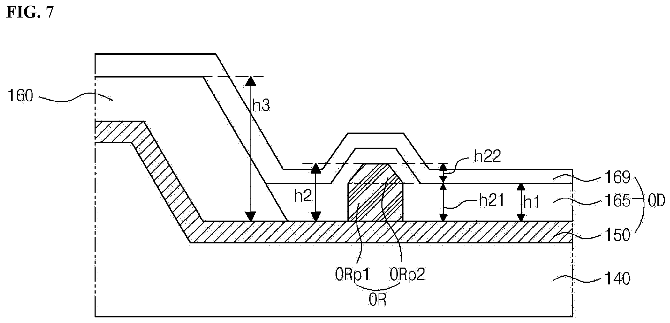

An example of a cross-sectional structure of the light reflector OR is described in more detail with reference to FIG. 7.

FIG. 7 is a schematic cross-sectional view illustrating an example of a cross-sectional structure of a light reflector according to a first aspect of the present disclosure.

Referring to FIGs. 1 and 7, the light reflector OR of this aspect may include a first portion ORp1 (e.g., a lower portion) and second portion ORp2 (e.g., an upper portion).

A side surface of the first portion ORp1 may have a very steep inclination angle, for example, an inclination angle of about 80 degrees to 90 degrees, but is not limited thereto. A height (or thickness) h21 (or first partial height) of the first portion ORp1 may be equal to or greater than the height (or thickness) h1 of the emission layer 165 around the light reflector OR.

By configuring the first portion ORp1 having the height h21 higher than that of the emission layer 165, light traveling in the horizontal direction either passes through the light reflector OR or is totally reflected by the light reflector OR based on an incident angle while maintaining a substantially horizontal direction.

The second part ORp2 on the first part ORp1 may have a side surface which has a smaller inclination angle than the first part ORp1, for example, has an inclination angle of about 40 degrees to 50 degrees, but is limited thereto. The inclination angle of the side surface of the second portion ORp2 may be equal to or smaller than that of the side surface SSb of the bank 160.

In some aspects, deterioration in step coverage characteristics of the second electrode 169 which is formed along the upper portion of the light reflector OR may be prevented based on the second portion ORp2 having a relatively low inclination angle.

A height h22 of the second portion ORp2 may be formed equal to or less than the height h21 of the first portion ORp1 in consideration of the step coverage characteristics of the second electrode 169, but is not limited thereto.

In this aspect, as mentioned above, the light reflector OR may be made of an insulating material having a lower refractive index than the emission layer 165 and causing a total reflection, and this may realize a higher light extraction efficiency as compared to a highly reflective surface such as a metal material.

In this regard, for example, in a case that the light reflector is formed of a metal material of the first electrode 150, a significant amount of the waveguide mode light traveling in the horizontal direction, for example, about 50% is reflected between the first electrode 150 and the second electrode 169 and converts into a waveguide mode, and thus is not extracted to the outside. In this case, the reflected light is absorbed into the medium.

Therefore, as in this aspect, the light reflector OR formed of a material with a low refractive index reduces loss of the waveguide mode light and maximizes light extraction efficiency.

### Second Aspect

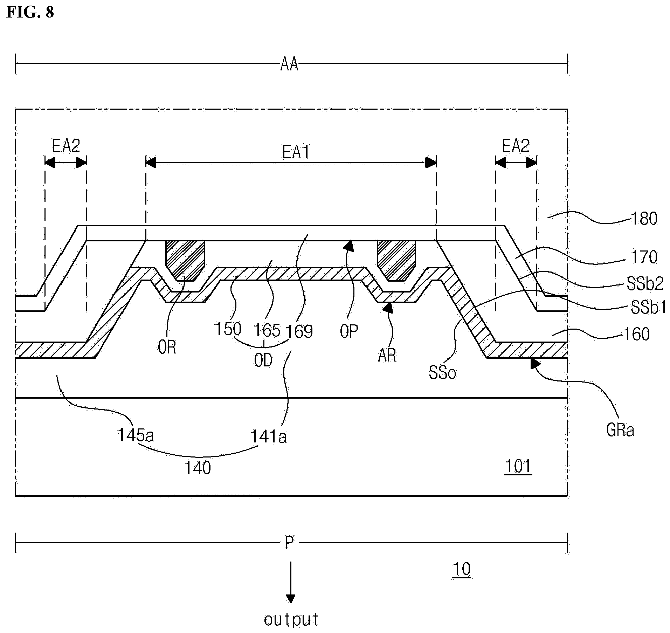

FIG. 8 is a schematic cross-sectional view illustrating a cross-sectional structure of a light emitting display device according to a second aspect of the present disclosure.

In the following description, detailed explanations of components identical or similar to those of the first aspect described above may be omitted.

In FIG. 8, for convenience of description, one pixel region P is shown, and components between the substrate 101 and the overcoat layer 140 are omitted.

Referring to FIG. 8, the light emitting display device 10 of this aspect may be configured in a bottom emission type that emits light through a substrate.

According to the configuration of the bottom emission type, a structure of the overcoat layer 140, the light emitting diode OD, and the reflective portion 170 may be different from the structure of the first aspect described above.

In this regard, for example, the overcoat layer 140 may include a protruding portion 141a corresponding to the first emission region EA1 of the pixel region P and a concave groove GRa formed along the boundary of the pixel region P. As such, the arrangement relationship between the protruding portion 141a and the concave groove GRa of the overcoat layer 140 may be substantially opposite to that in the first aspect.

A portion of the overcoat layer 140 that is located below the concave groove GRa may have an upper surface which is substantially flat, and may be referred to as a flat portion (or base portion) 145a.

In addition, the protruding portion 141a may be configured to have a tapered shape with a decreasing width in an upward direction opposite to a direction in which light is emitted. In other words, the protruding portion 141a may be configured to have a tapered shape in which a width increases in a downward direction, which is the direction in which light is emitted.

Accordingly, the protruding portion 141a may be configured with a side surface SSo as an inclined surface Sso.

Meanwhile, in the protruding portion 141a of the overcoat layer 140, an accommodation groove AG recessed toward the substrate 101 may be formed to accommodate the light reflector OR. For example, the light reflector OR may be formed or inserted into the groove.

In some aspects, the first electrode 150 may be formed separately in each pixel region P on the overcoat layer 140.

In this regard, the first electrodes 150 may be positioned to correspond to each protruding portion 141a of the overcoat layer 140 and may have a structure separated from the first electrode 150 of a neighboring pixel region P with the concave groove GRa interposed therebetween.

The first electrode 150 may be formed of a transparent electrode having a transparent property, and in this case, may be formed of a transparent conductive material such as ITO.

Meanwhile, to realize a micro cavity effect in a vertical direction, the first electrode 150 may be configured to include a semi-transparent electrode layer having a semi-transparent property, and may have a multi-layered structure including the semi-transparent electrode layer. The semi-transparent electrode layer of the first electrode 150 may be formed of, but not limited to, for example, a metal material such as magnesium (Mg), silver (Ag), or an alloy (MgAg) of magnesium (Mg) and silver (Ag). The metal material may be formed with a thickness thin enough to realize a semi-transparent property.

The first electrode 150 may be formed along the surface of the protruding portion 141a of the overcoat layer 140, so that the first electrode may be formed in the accommodation groove AR of the protruding portion 141a.

The emission layer 165 may be formed on the first electrode 150. In this aspect, for convenience of description, a case in which the emission layer 165 is formed corresponding to the first emission region EA1 is taken as an example.

Since the emission layer 165 is formed along the surface of the first electrode 150, the emission layer 165 may be formed in the accommodation groove AR of the protruding portion 141a.

The bank 160 covering the edge of the first electrode 150 may be formed on the substrate 101 having the emission layer 165. The bank 160 may be disposed along the boundary of the pixel region P, cover an edge portion of the first electrode 150, and fill the concave groove GRa of the overcoat layer 140.

The bank 160 may have an opening OP therein exposing the emission layer 165 of each pixel region P.

The bank 160 may be formed in substantially the same shape as (or a shape corresponding to) the overcoat layer 140.

In this regard, the bank 160 may be configured to have a tapered shape with a width being narrower in a downward direction. The tapered shape of the bank 160 may be the same as that of the concave groove GRa of the overcoat layer 140 positioned therebelow.

Accordingly, the bank 160 may be configured such that an inner side surface SSb1 and an outer side surface SSb2 as side surfaces thereof are formed of inclined surfaces SSb1 and SSb2. The inner and outer inclined surfaces SSb1 and SSb2 of the bank 160 may have substantially the same or based on an inclination angle of the inclined surface SSo of the protruding portion 141a located therebelow.

The inner inclined surface SSb1 of the bank 160 may surround the opening OP. Accordingly, the opening OP has an inclined side surface corresponding to the inner inclined surface SSb1.

The second electrode 169 may be formed on the emission layer 165 and the bank 160 and over the entire surface of the substrate 101.

The second electrode 169 may include a metal material with high reflectance. For example, the second electrode 169 may include Al, Ag, Ti, or an Al-Pd-Cu (APC) alloy, but is not limited thereto.

Meanwhile, the second electrode 169 may have a single-layered structure or a multi-layered structure. When formed in a multi-layered structure, for example, the second electrode 169 may have a laminated structure of Al and Ti (e.g., Ti/Al/Ti), a laminated structure of Al and ITO (e.g., ITO/Al/ITO), a laminated structure of an APC alloy and ITO (e.g., ITO/APC/ITO), etc., but is not limited thereto.

The second electrode 169 may include a reflective portion (or inclined portion) 170 formed along the outer inclined surface SSb2 of the bank 160.

A region where the reflective portion 170 of the second electrode 169 is disposed may be a reflective emission region in which light generated in the emission layer 165 located inside the region and then propagated in the lateral direction. A portion of the light is reflected and emitted downward, and this region may be referred to as the second emission region EA2.

The encapsulation layer 180 may be formed on the second electrode 169. The encapsulation layer 180 may prevent oxygen or moisture from permeating into the light emitting diode OD.

Meanwhile, although not specifically shown, between the substrate 101 and the overcoat layer 140, a thin film transistor (T of FIG. 1) connected to the first electrode 150 through a contact hole, and a color filter layer (195 of FIG. 1) may be disposed.

In the light emitting display device 10 of this aspect configured as described above, the pixel region P may be formed in a circular (or elliptical) shape in plan view.

Regarding the case of the pixel region P being formed in a circular shape, for example, the opening OP and the light emitting diodes OD disposed therein (or the light emitting diodes OD disposed in the first emission region EA1) may be formed in a circular shape in plan view. In addition, the reflective portion 170 surrounding the opening OP and the light emitting diode OD may also be formed in a circular shape in a plan view corresponding to the opening OP and the light emitting diode OD.

As such, when the pixel region P is formed in a circular structure, a waveguide mode light may exist that is totally reflected along the interface between the emission layer 165 and the bank 160 and rotates in a stable trajectory, and the linear light reflector OR may be disposed inside the light emitting diode OD to block or disperse the path of the waveguide mode light.

The light reflector OR may be configured to protrude in a downward direction from the lower surface of the second electrode 169 toward the substrate 101 according to the structure of the bottom emission type light emitting diode OD.

In this regard, for example, the light reflector OR may be formed such that its upper surface contacts the lower surface of the second electrode 169 and the light reflector OR is inserted (or accommodated) into the accommodation groove AR.

Accordingly, within the accommodating groove AR, the light reflector OR may be formed such that its side surface and lower surface contact the emission layer 165 (or be surrounded by the emission layer 165).

The light reflector AR may be formed of the same material and in the same process as the bank 160. As another example, the light reflector OR may be formed in a process different from that of the bank 160, and in this case, the light reflector OR may be formed of the same material as the bank 160 or a different material from the bank 160.

In addition, the light reflector OR has a refractive index lower than that of the emission layer 165 and may have a refractive index equal to or smaller than that of the bank 160.

In order for the light reflector OR to prevent the path of the waveguide mode light along the circular total reflection interface between the light emitting layer 165 and the bank 160, as in the first aspect described above, at least a portion of the light reflector OR may be located in the caustic region (CA of FIGs. 3 and 4). A caustic region is a total reflection optical path region that prevents the light from leaving this region due to an incident angle.

Accordingly, the path of the waveguide mode light is changed to pass through the interface between the emission layer 165 and the bank 160, thereby maximizing the light extraction efficiency.

As described above, according to the aspects of the present disclosure, inside the light emitting diode forming the circular total reflection interface with the bank, the low refractive light reflector realizing the linear total reflection interface different from the circular total reflection interface may be formed.

Accordingly, in the light emitting diode, the chaotic dynamics structure may be implemented in which the circular total reflection interface and the linear total reflection interface inside the circular total reflection interface are combined to make the motion trajectory of light in a chaotic state.

Accordingly, the stable path of the waveguide mode light along the circular total reflection interface is destroyed to disperse the light path, thereby making the path of the waveguide mode light unstable.

Therefore, the incident angle of the waveguide mode light is sharply changed to less than the total reflection critical angle of the circular total reflection interface, the light extraction efficiency may be maximized.

Moreover, as described above, the light emitting display device according to the present aspects may have the improved light extraction efficiency, so that power consumption may be reduced and thus the light emitting display device may be driven with low power.

It will be apparent to those skilled in the art that various modifications and variation may be made in the present disclosure without departing from the spirit or scope of the disclosure. Thus, it is intended that the present disclosure cover the modifications and variations of this disclosure provided they come within the scope of the appended claims and their equivalents.

## Claims

1. A light emitting device, comprising:
a substrate (101) on which a pixel region (P) with an emission region is defined;
a bank (160) disposed on the substrate (101) and including an opening (OP) corresponding to the emission region of the pixel region (P);
a light emitting diode (OD) disposed in the pixel region (P) and including a first electrode (150), an emission layer (165) on the first electrode (150) and a second electrode (169) disposed on the emission layer (165),
an inclined reflective portion (151) disposed around the light emitting diode (OD); and
a plurality of light reflectors (OR) disposed within the emission region inside the light emitting diode (OD) and having a refractive index less than a refractive index of the emission layer (165),
wherein a first interface between the emission layer (165) and the bank (160) is non-linear, and a second interface between a first light reflector (OR1) of the plurality of light reflectors (OR) and the emission layer (165) is linear, and
wherein at least a portion of one of the light reflectors (OR) is disposed in a caustic region (CA) along the first interface.

2. The light emitting device of claim 1, wherein the first light reflector (OR1) and a second light reflector (OR2) of the plurality of light reflectors have different extension directions in the emission region.

3. The light emitting device of claim 1 or 2, wherein the first light reflector (OR1) is configured to reflect incident light to the inclined reflective portion (151).

4. The light emitting device according to any one of the preceding claims, wherein each of the light reflectors (OR) has a height (h2) equal to or greater than a height (h1) of the emission layer (165) surrounding the light reflector (OR) and/or a height less than a height (h3) of the bank (160).

5. The light emitting device of claim 4, wherein the light reflector (OR) includes:
a first portion (ORp1) having a height (h21) equal to or greater than the height (h1) of the emission layer (165) and/or having a side surface which has a first inclination angle.

6. The light emitting device of claim 5, wherein the light reflector (OR) includes further a second portion (ORp2) on the first portion (ORp1) and having a side surface which has a second inclination angle smaller than the first inclination angle.

7. The light emitting device according to any one of the preceding claims, wherein the inclined reflective portion (151) has a circular or elliptical shape and/or a shape corresponding to a shape of the first interface.

8. The light emitting device according to any one of the preceding claims, wherein the inclined reflective portion (151) extends from the first electrode (150) and/or is disposed below the bank (160).

9. The light emitting device according to any one of the preceding claims, wherein the light emitting diode (OD) is configured in a top emission type.

10. The light emitting device according to any one of claims 1 to 7, wherein the light emitting diode (OD) is configured in a bottom emission type, and
wherein the inclined reflective portion (151) extends from the second electrode (169) and/or is disposed on the bank (160).

11. The light emitting device according to any one of the preceding claims, wherein the light reflector (OR) that is disposed in the caustic region (CA) is configured to reflect light to an outside of the caustic region (CA).

12. The light emitting device according to any one of the preceding claims, wherein the light reflectors (OR) are disposed between the first electrode (150) and the second electrode (169).

13. The light emitting device according to any one of the preceding claims, wherein each of plurality of light reflectors (OR) is configured to change a direction of light traveling in a lateral direction.

14. The light emitting device according to any one of the preceding claims, wherein each of plurality of light reflectors (OR) is configured to redirect light to the inclined reflective portion (151).
